# EUROPÄISCHE PATENTANMELDUNG

(11) **EP 4 661 609 A1**
(43) Veröffentlichungstag der Anmeldung: **10.12.2025**
(21) Anmeldenummer: 24180372.5
(22) Anmeldetag: 06.06.2024
(51) Int. Cl.: H05K 7/20, G05B 1/00, G05B 23/02, H02P 29/60

(54) **LEBENSDAUERERHÖHENDES VERFAHREN MITTELS TEMPERATURREGULIERUNG EINES ELEKTRONISCHEN BAUTEILS BERUHEND AUF EINER LASTPROGNOSE**

(71) Anmelder: Siemens Aktiengesellschaft, 80333 München (DE)
(72) Erfinder: Bischoff, Martin, 85653 Aying, Großhelfendorf (DE); Madkour, Sherif, 12159 Berlin (DE); Nielebock, Sebastian, 91301 Forchheim (DE); Stegmeier, Stefan, 81825 München (DE)
(74) Vertreter: Siemens Patent Attorneys

(57) **Zusammenfassung**

Das vorgeschlagene computerimplementierte Verfahren weist folgende Aspekte auf: die Laststeuerung überträgt aktuelle Temperaturmessdaten des elektronischen Bauteils an die Temperaturregulierung sowie an die Temperatursimulation, aktuelle Lastmessdaten und Temperaturmessdaten des elektronischen Bauteils werden außerdem an die Ki-basierte Lastprognose und an das KI-Training übertragen. Es erfolgt eine Priorisierung der Lebensdauerverlängerung gegenüber der sofortigen Effizienzmaximierung, da die Lebensdauer zu einem kritischen Designkriterium in der gesamten Elektronik geworden ist. Dazu wird eine Temperaturregulierung des elektronischen Bauteils mittels der Laststeuerung sowie wahlweise aktivem Wärmemanagement vorgenommen.

## Beschreibung

Die vorliegende Erfindung betrifft ein computerimplementiertes Verfahren sowie Anordnung zur Durchführung des Verfahrens zur Steuerung eines elektronischen Bauteils.

### Stand der Technik

Im Bereich elektrischer Systeme, insbesondere elektronischer Bauteile, stellt die Variabilität des Leistungsbedarfs eine immense technische Herausforderung dar. Die elektronischen Geräte werden thermischer Belastung ausgesetzt und dadurch eine Materialermüdung verursacht. Dieses Phänomen ist in erster Linie auf die unaufhörlichen Änderungen des Leistungsbedarfs zurückzuführen. Diese Schwankungen lösen während der Lebensdauer der Geräte eine Vielzahl von Temperaturzyklen aus. Die Folge jedes Temperaturzyklus ist die Induktion von thermomechanischem Stress. Aufgrund von unterschiedlichen thermischen Ausdehnungskoeffizienten entsteht mechanischer Stress explizit an Übergangsschichten (CTE mismatch). Dieser thermomechanische Stress betrifft nicht nur Halbleiter-Dies, sondern auch verschiedene Komponenten innerhalb der Elektronikmodule. Diese Komponenten zeichnen sich durch unterschiedliche Wärmeausdehnungskoeffizienten aus, was zu unterschiedlichen Reaktionen auf thermische Spannungen führt. Folglich führt die kumulative Wirkung dieser Belastungen, die durch wiederholte Temperaturzyklen hervorgerufen wird, möglicherweise zu einer beschleunigten Degradation und schließlich zum Ausfall der Verbindungsstelle zum Elektronikmodul. Dieses Problem wird durch die unvorhersehbaren Schwankungen des Strombedarfs verschärft, was eine erhebliche Herausforderung für das effektive Management und die Reduzierung der damit verbundenen thermischen Belastung darstellt, um die Langlebigkeit und Zuverlässigkeit von elektronischen Geräten zu verbessern.

Die thermische Ermüdung ist dabei aber nicht auf leistungselektronische Geräte beschränkt, sondern betrifft verschiedene elektrische Systeme, einschließlich Batterien, allgemeine Leiterplatten (PCBs), einschließlich Zentralprozessoren (CPUs) und Grafikprozessoren (GPUs) oder Elektromotoren.

Folglich stellt es sich als technisch erforderlich dar, eine verbesserte Lösung vorzuschlagen, welche die aus dem Stand der Technik bekannten Nachteile vermeidet. Insbesondere soll die vorzuschlagende Lösung eine thermische Ermüdung des elektronischen Bauteils reduzieren beziehungsweise verzögern.

### Beschreibung der Erfindung

Das erfindungsgemäße computerimplementierte Verfahren umfasst eine Temperaturregulierung eines elektronischen Bauteils, insbesondere eines leistungselektronischen Bauteils. Für die Temperaturregulierung wird eine Lastprognose für das elektronische Bauteil vorgenommen, welche in eine Temperatursimulation eingeht. Mittels der Temperatursimulation wird eine Temperaturvorhersage über einen bestimmten Zeitraum für das elektronische Bauteil bestimmt, wobei in die Temperatursimulation außerdem Lastmessdaten sowie Temperaturmessdaten des elektronischen Bauteils eingehen. Die Lastprognose wird dabei Kt-basiert erstellt. Und beruhend auf Lastprognose und Temperaturvorhersage erfolgt die Temperaturregulierung des elektronischen Bauteils mittels der Laststeuerung.

Die Erfindung nutzt strategisch elektrische Energie, um Temperaturniveaus unter bestimmten Bedingungen zu regulieren, wodurch die Gesamtlebensdauer von elektronischen Geräten vorteilhaft verlängert wird.

Dieser Ansatz priorisiert die Verlängerung der Lebensdauer gegenüber der sofortigen Effizienzmaximierung, eine Abweichung von herkömmlichen Design- und Betriebspraktiken, die in der Regel darauf abzielen, Energieverluste zu minimieren. Die Lebensdauer ist ein kritisches Designkriterium in der gesamten Leistungselektronik-Systemarchitektur. Die Auswahl von Leistungsmodulen, Kühlketten und Montagetechnologien basiert auf definierten Lastzyklen und zu erwartenden Lebensdauern. Die Herausforderung liegt insbesondere darin, zwischen unterschiedlichen Anwendungsanforderungen zu unterscheiden, wie zum Beispiel bei Pumpen-, Lüfter- und Krananwendungen. Die gleiche Leistungseinheit, die in diesen Anwendungen eingesetzt wird, weist ein unterschiedliches Lebensdauerverhalten auf.

In einer vorteilhaften Variante des erfindungsgemäßen computerimplementierten Verfahrens, werden mittels der Laststeuerung, basierend auf Sollwerten, empfangen aus der Temperaturregulierung, thermische als auch elektrische Leistungsparameter des elektronischen Bauteils gesteuert.

Insbesondere umfasst dabei die Laststeuerung eine Anpassung von Leistungsparametern wie beispielsweise der Blindleistung, eine Variation einer Schaltfrequenz oder eine Modulation einer Schaltgeschwindigkeit.

Bevorzugt liegen in einer Systemsteuerung des elektronischen Bauteils Werte vor, insbesondere Betriebsgrenzwerte, die an die Temperaturregulierung mitgeteilt werden.

Insbesondere werden der Temperaturregulierung weitere Daten zur Verfügung gestellt, beispielsweise Stromtarifpreise, Tarifprognosen und/oder Nutzerkonfigurationen.

In einer weiteren vorteilhaften Variante des erfindungsgemäßen computerimplementierten Verfahrens, umfassen die Temperaturmessdaten, welche in die Temperatursimulation eingehen, zumindest die Temperatur einer Komponente des elektronischen Bauteils, insbesondere die Temperatur einer Kühlkomponente.

Unter Kühlkomponente ist grundsätzlich jedes Gerät zu verstehen, das zur Wärmeableitung vorsehbar ist. Dies umfasst passive Kühlvorrichtungen wie Kühlkörper und auch aktive Kühlmethoden wie Kühlmittelpumpen. Im Falle von Ventilatoren ist auf Grund der konvektionsbasierten Wärmeübertragung keine direkte Temperaturmessung möglich. Demnach könnte dann alternativ ein anderer Temperaturwert, insbesondere der einer luftgekühlten Komponente herangezogen werden. Es können Einlasstemperatur oder Hotspot-Temperatur bestimmt werden, je nachdem welche die interessierende Komponente ist.

Vorgeschlagen wird demnach eine Strategie zur Verlängerung der Lebensdauer von leistungselektronischen Geräten, bei der der Energieverbrauch absichtlich gesteuert wird, um die Langlebigkeit der Geräte in verschiedenen Anwendungen zu verbessern.

In der vorstehend beschriebenen Variante des erfindungsgemäßen computerimplementierten Verfahrens, werden bevorzugt Temperaturwerte weiterer einzelner Komponenten des elektronischen Bauteils, insbesondere einzelner IGBTs und/oder Dioden, anhand eines thermischen Modells berechnet.

Zum Beispiel wird bei dem vorgeschlagenen computerimplementierten Verfahren das thermische Modell aus einer 3D-Thermosimulation abgeleitet, welche 3D-Thermosimulation komponentenübergreifende Kopplungen unter Verwendung einer Modellreduktion berücksichtigt.

In einer der beiden vorstehend beschriebenen Varianten des erfindungsgemäßen computerimplementierten Verfahrens, kann bevorzugt, basierend auf der Lastprognose für mehrere Komponenten innerhalb des elektronischen Bauteils, jeweils ein individuelles Temperaturprofil generiert werden.

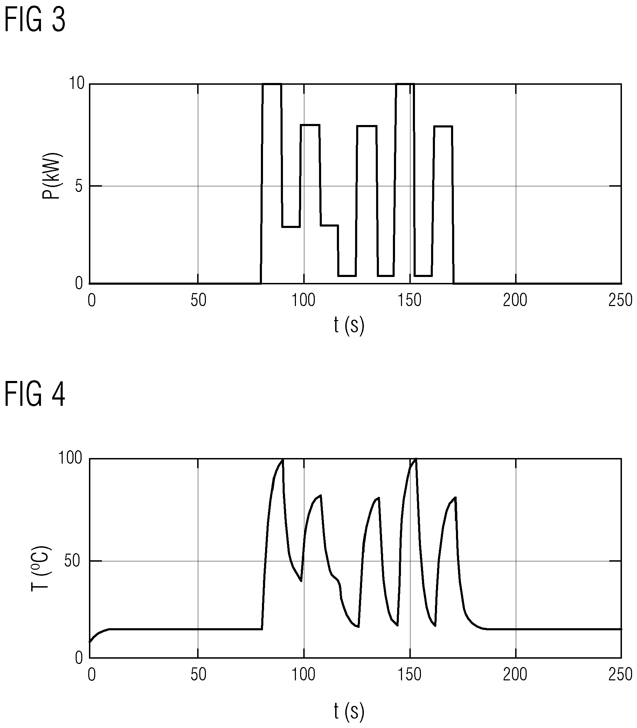

In der Figur 4 ist beispielsweise so ein Temperaturprofil dargestellt. Damit kann dann entschieden werden, welche Täler man durch zusätzliche Erwärmung überbrücken möchte, um die Lebensdauer zu verlängern.

In einer sehr vorteilhaften Variante des erfindungsgemäßen computerimplementierten Verfahrens, erfolgt die Temperaturregulierung des elektronischen Bauteils mittels aktivem Wärmemanagement. Unter Wärmemanagement kann beispielsweise ein Abkühlprozess verstanden werden. Es gibt aber auch Szenarien, in denen eine leistungselektronische Komponente bewusst erwärmt wird.

Dabei umfasst das aktive Wärmemanagement bevorzugt einen Abkühlprozesses, welcher Abkühlprozess eine Steuerung eines Flüssigkeitspumpenstroms, eine Steuerung einer Lüfterdrehzahl, eine Regelung einer Blindleistung, eine Regelung einer Energieabgabe und/oder ein Anlegen einer disponierbaren Last zur Feinabstimmung der Abkühlfähigkeit umfasst.

Im Steuerungsprozess gibt es demnach bevorzugt zwei Schritte: Mittels der Laststeuerung werden die Betriebsabläufe anhand der generierten Lastprognose angepasst. Dabei werden vorgegebene Sollwerte angewendet. Diese Sollwerte werden insbesondere von der Temperaturregelung empfangen. Diese Laststeuerung verwaltet die elektrischen Leistungsparameter des elektronischen Bauteils sowie des Kühlsystems, welche wiederum die thermischen Parameter kontrollieren. Zusätzlich zur Laststeuerung erfolgt eine Temperaturregulierung, wobei die optimierte Last dann ein aktives Management des thermischen Systems ermöglicht. Die Temperaturregulierung kann mittels Steuerung passiver Kühlungssysteme sowie Steuerung aktiver Kühlungssysteme, insbesondere mittels Steuerung von Festkörperkühlern, beispielsweise thermoelektrischen Kühlsysteme, erfolgen.

In einer der beiden vorstehend beschriebenen Varianten des erfindungsgemäßen computerimplementierten Verfahrens wird dazu ein Zwei-Kriterien-Problem gelöst, insbesondere aus Temperaturschwankungsminimierung und Energieeffizienz oder Energieverfügbarkeit. Insbesondere wird dies mittels eines KI-Algorithmus gelöst. Das aktive Wärmemanagement wird dazu auf die Abkühlfähigkeit des im elektronischen Bauteil eingesetzten Abkühlsystems abgestimmt.

Mit diesem Ansatz wird der Aufgabe begegnet, zu bestimmen, wie sehr man auf die Abkühlkurve einwirken möchte, um Temperaturschwankungen zu minimieren. Diese Berechnung benötigt die Lastprognose als einen Input. Entsprechend ist der Ansatz mit dem bikriteriellen Optimierungsproblem ergänzend: es muss ein geeigneter Gewichtungsfaktorzwischen den beiden Kriterien gewählt werden, um das Optimum zu berechnen. Die Energieverfügbarkeit kann beispielsweise auch von Energiekosten beziehungsweise Strompreisen abhängig gemacht werden.

Besonders vorteilhaft erfolgt in einer Ausführungsform des erfindungsgemäßen Verfahrens ein Dateninput in die Kt-basierte Lastprognose, insbesondere ein Dateninput, der eine Datenhistorie umfasst. Dieser Dateninput kann beispielsweise umfassen: verschiedene Ist-Werte, zum Beispiel Messdaten, insbesondere tatsächliche Lastwerte eines Wechselrichters, Steuereingang für den Temperaturausgleich, Datum und/oder Uhrzeit, beispielsweise wichtig bei zeitspezifischen Lastzyklen von Wechselrichtern, weitere anwendungsspezifische Lastparameter, wie etwa Wettervorhersage, Sonnenstand, und ähnliches, weitere anwendungsspezifische Lastparameter, zum Beispiel ob der aktuelle Tag ein Arbeitstag ist, geplante Lastpläne von Verbrauchern oder Stromquellen in einem Inselnetz, eine Verkehrsprognose, eine Wetterprognose, einen Produktionsplan, insbesondere für die folgenden Stunden, allgemein eine Wertehistorie, insbesondere eine durch das Verfahren selbst angelegte Wertehistorie, zum Beispiel durch die kontinuierlich aktualisierten Input-Daten. Der Input muss je nach Anwendung passend gewählt werden.

In einer weiteren bevorzugten Variante des erfindungsgemäßen computerimplementierten Verfahrens, erfolgt ein Input von Messdaten des elektronischen Bauteils in die KI-basierte Lastprognose. Besonders vorteilhaft wird die Lastprognose-Kl kontinuierlich während der Ausführung des Verfahrens trainiert.

In der vorstehend beschriebenen Variante des erfindungsgemäßen computerimplementierten Verfahrens, erfolgt zudem beispielsweise ein Input von Lastmessdaten und/oder Temperaturmessdaten des elektronischen Bauteils in das KI-Training.

Insbesondere wird bei dem im KI-Training eine überwachte Lernmethode (Supervised Learning Method SL) angewendet. Alternativ wird eine alternative Kategorie des maschinenellen Lernens angewendet, beispielsweise unüberwachtes Lernen (Unsupervised Learning Method UL) oder verstärktes Lernen (Reinforcement Learning RL).

Zwar ist es durchaus abhängig von der Art der Anwendung, von Investitionskosten, von Energiekosten und abhängig vom COz-Footprint der verbrauchten Energie, wie groß der Benefit der vorgeschlagenen Herangehensweise ist. Jedoch im Hinblick auf Nachhaltigkeit, dynamische Strompreise und Zeiten des Stromüberschusses durch erneuerbare Energien wird das vorgeschlagene Verfahren zunehmend an Bedeutung gewinnen. Bei Li-lonen-Batterien etwa, ist die Batteriekonditionierung, also das Vorheizen von Batterien vor starken Ladevorgängen und auch Entladevorgängen, bereits eine vorteilsbehaftete gängige Maßnahme ist.

Die vorgeschlagene Lösung bietet daher eine breitere Anwendbarkeit und befasst sich mit dem Problem der thermischen Ermüdung in diesen Systemen. Diese Erweiterung ist von entscheidender Bedeutung, da diese Systeme, ähnlich wie leistungselektronische Geräte, aufgrund des schwankenden Leistungsbedarfs ähnlichen thermischen Belastungen ausgesetzt sind. Durch die Anwendung der Prinzipien und Lösungen, die für leistungselektronische Geräte entwickelt wurden, auf diese anderen Systeme ebnet die Erfindung den Weg für einen umfassenderen Ansatz zur Bekämpfung der thermischen Ermüdung.

Die erfindungsgemäße Anordnung zur Durchführung des vorstehend beschriebenen computerimplementierten Verfahrens, umfasst eine Hardwarekomponente, insbesondere ein elektronisches Bauteil mit einer Laststeuerung und Temperaturregulierung, sowie eine Softwarekomponente, insbesondere mit einer Temperatursimulation und Kt-basierten Lastprognose. Die Softwarekomponente kann insbesondere auf einem Edgedevice vorliegen, beziehungsweise ausführbar sein. Laststeuerung und Temperaturregulierung können in, beziehungsweise auf dem elektronischen Bauteil integriert vorliegen.

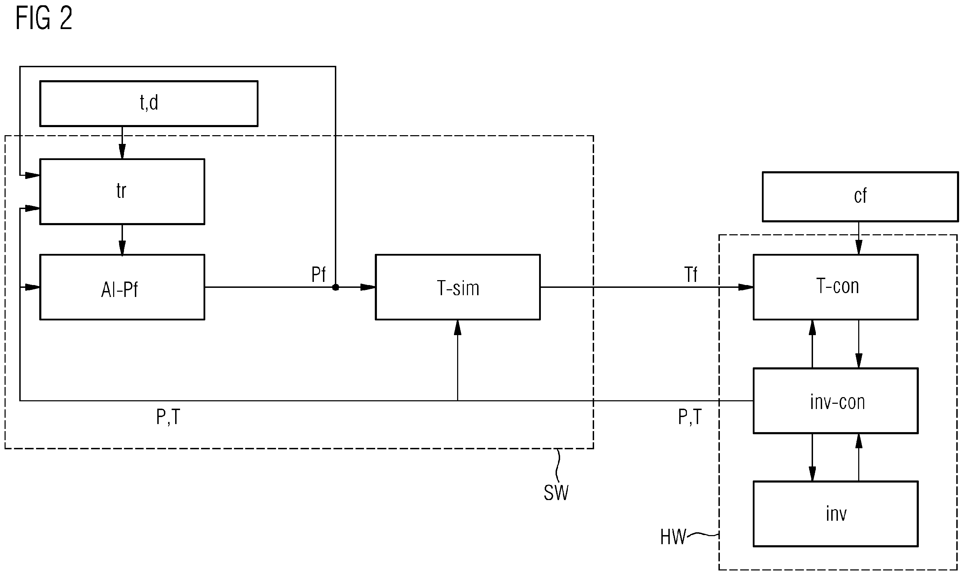

Beispiele und Ausführungsformen der vorliegenden Erfindung werden noch in exemplarischer Weise mit Bezug auf die Figuren 1 bis 6 der angehängten Zeichnung beschrieben:
- Figur 1: zeigt ein Ablaufdiagramm einer geschlossenen Temperaturregelung eines elektronischen Bauteils inv,
- Figur 2: zeigt eine mögliche Aufteilung der einzelnen dafür erforderlichen Komponenten,
- Figur 3: zeigt ein Lastprofil P in Kilowatt in Abhängigkeit von der Zeit t in Sekunden,
- Figur 4: zeigt ein Temperaturprofil T in °C in Abhängigkeit von der Zeit t in Sekunden,
- Figur 5: zeigt die relative Lebensdauerverlängerung Inc (%) (Increase of Lifetime) in Abhängigkeit von der aktuellen Leistung in Bezug auf die Nominalleistung in Prozent Ref (%) und
- Figur 6: zeigt die mittlere Effizienz Eff (%) in Abhängigkeit von der aktuellen Leistung in Bezug auf die Nominalleistung in Prozent Ref (%).

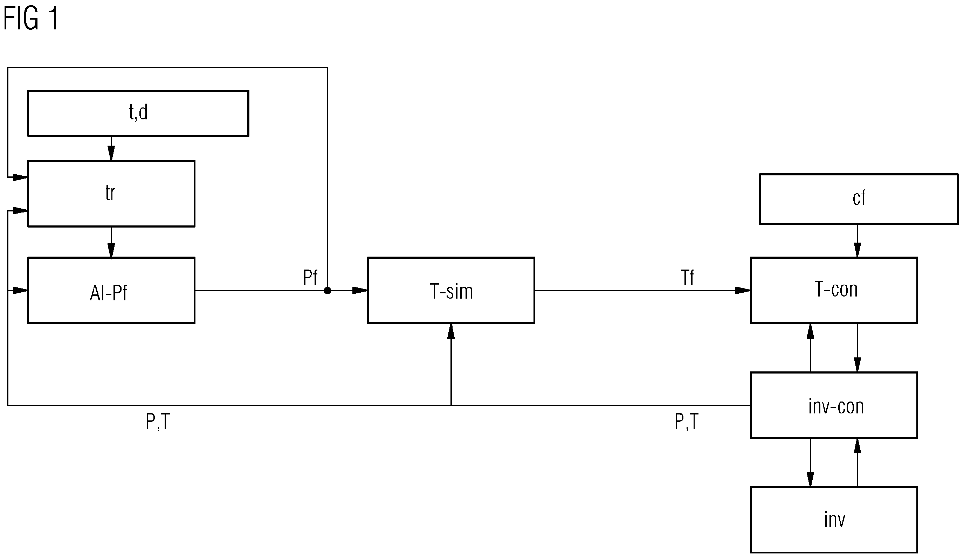

Figur 1 zeigt die geschlossene Regelung zur Temperaturanpassung eines elektronischen Bauteils inv. Sie besteht aus den folgenden Komponenten, zunächst der KI-basierten Lastprognose Al-Pf, einem Lastprognosemodell. Diese Komponente ist insbesondere eine Softwarekomponente oder in einer Softwarekomponente enthalten. In die Kt-basierte Lastprognose AI-Pf geht eine Reihe von Ist-Werten P/T als Eingabeparameter ein. Sie liefert dann eine Lastprognose (Power forecast) Pf für einen bestimmten Zeitraum. Abhängig von der Anwendung beziehungsweise abhängig von der Funktion des elektronischen Bauteils inv ist eine typische sinnvolle Prognosezeit beispielsweise zwischen 5 und 60 Minuten. Die Prognosezeit sollte ausreichend lang sein, um "kurze" Täler im Lastprofil P(t), vergleiche Figur 3, zu identifizieren, für die es vorteilhaft ist, eine Temperaturregelung T-con zur Ausgleichung anzuwenden.

Als Ist-Werte sind die tatsächliche Last P des elektronischen Bauteils, beispielsweise eines Wechselrichters inv und ein Temperaturmesswert T erforderlich, welcher Temperaturmesswert T gleichermaßen Eingangswert für die Temperaturanpassungsregelung T-con ist. Da die typischen Lastzyklen P(t) eines Wechselrichters inv von Zeit t und Datum d abhängen, werden diese in einer bevorzugten Ausführungsform ebenso als zusätzliche Parameter eingespeist. Darüber hinaus können weitere anwendungsspezifische Lastparameter hinzugefügt werden, wie zum Beispiel Wettervorhersage und Sonnenposition, ob der aktuelle Tag ein Arbeitstag ist, geplante Lastpläne von Verbrauchern oder Stromquellen in einem Inselnetz. Im Allgemeinen sollten eine Reihe notwendiger und ausreichender Daten bereitgestellt werden, mit denen eine möglichst genaue Lastprognose Pf erstellt werden kann.

Neben den Ist-Werten werden auch historische Daten über einen bestimmten vergangenen Zeitraum benötigt, damit die KI genaue Prognosen Pf erstellen kann. Diese Daten werden intern gesammelt und verarbeitet, indem geeignete Netzwerkarchitekturen wie beispielsweise LSTM (Long-Short-Term-Memory) verwendet werden.

Eine weitere Komponente der geschlossenen Regelung zur Temperaturanpassung eines elektronischen Bauteils inv ist das Training tr des Lastprognosemodells Al-Pf. Beispielsweise wird das Lastprognosemodell Al-Pf über ein sogenanntes Online-Lernen während des Betriebs kontinuierlich trainiert tr. Dabei wird die tatsächliche Last P mit der zuvor generierten Lastprognose Pf verglichen. Der Prognosefehler wird bevorzugt durch Anwendung einer überwachten Lernmethode minimiert. Der Zeitaufwand für Gewichtungsaktualisierungen aufgrund des Online-Lernens ist in dieser Anwendung nicht entscheidend, da Prognosen Pf nicht unbedingt in festen Zeitintervallen bereitgestellt werden müssen. Daher sind relativ lange Aktualisierungsintervalle von bis zu 1 Minute möglich. Zudem können weitere Parameter cf, wie zum Beispiel eine Benutzerkonfiguration oder der Strompreis hinzugezogen werden. Hinzu kommt die Komponente der Temperatursimulation T-sim. In diese Temperatursimulation T-sim wird das Lastprognoseprofil Pf eingespeist. Mittels der Temperatursimulation T-sim wird basierend auf der tatsächlichen Temperatur T, einem weiteren Eingabeparameter, und dem Lastprognoseprofil Pf, ein Temperatur-Last-Profil generiert wird. Typischerweise wird als Temperaturmesswert Teine Kühlkörper- und/oder eine Leistungsmodultemperatur des elektronischen Bauteils inv gemessen. Außerdem können alle einzelnen Die-Temperaturen der IGBTs und Dioden mithilfe eines thermischen Modells berechnet werden. Derartige Modelle können beispielsweise aus einer 3D-Temperatursimulation abgeleitet werden, bei der alle Gerätekopplungen unter Berücksichtigung einer Modellreduktion berücksichtigt werden. Basierend auf einer Lastprognose Pf könnte demnach für jedes Die in einem Leistungsmodul inv ein individuelles Temperaturprofil T(t) generiert werden. Für andere Anwendungen neben Leistungselektronikgeräten kann dieses Bauteil inv durch ein entsprechendes physikalisches oder datenbasiertes Simulationsmodell ersetzt werden, um wichtige Temperaturen T zu berechnen.

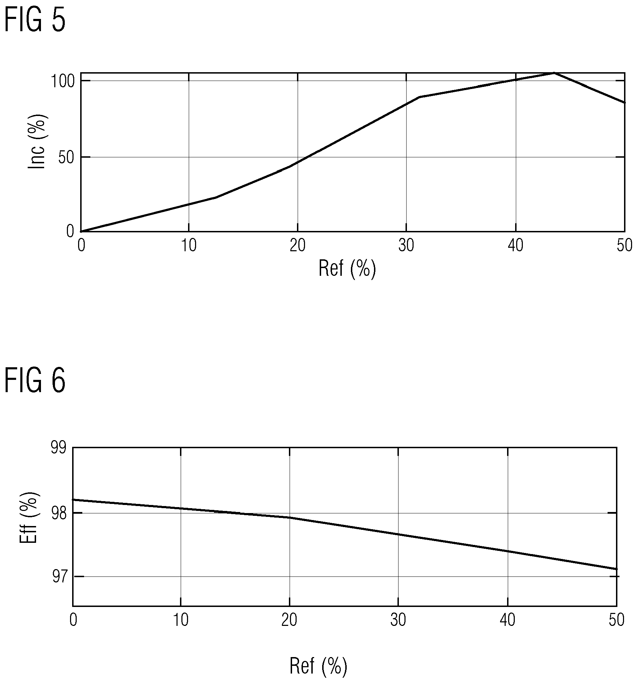

Eine weitere Komponente der geschlossenen Regelung zur Temperaturanpassung eines elektronischen Bauteils inv ist dann die Temperatursteuerung T-con. Unter Berücksichtigung des Temperaturprognoseprofils Tf besteht das Ziel der Temperatursteuerung T-con nicht darin, das Energienniveau gleichmäßig aufrechtzuerhalten, da dies ineffizient sein kann. Stattdessen konzentriert sich die Temperatursteuerung T-con darauf, hohe Temperaturschwankungen zu reduzieren, vgl. das in Figur 4 gezeigte Temperaturprofil T(t). Dies wird insbesondere durch effizientes Managen des Wärmeprozesses, insbesondere durch Eingreifen in den Abkühlprozess erreicht. Eine Herangehensweise sieht beispielsweise vor, die Abkühlungssteigung zu optimieren, insbesondere als Reaktion auf erwartete Hochlastbedingungen. Diese Optimierung variiert je nachdem, ob das System eine aktive oder passive Kühlung verwendet. Bei aktiver Kühlung können Anpassungen durch Steuerung des Flüssigkeitspumpenflusses oder der Lüftergeschwindigkeit vorgenommen werden. Im Falle einer passiven Kühlung können Methoden wie Blindleistungsregelung, Energieableitung oder die Anwendung von abrufbarer Last verwendet werden, um die Abkühlungssteigung feinabzustimmen. Der Entscheidungsprozess, der diese unterschiedlichen Faktoren berücksichtigt und darauf abzielt, die Delta-Temperatur effektiv zu reduzieren, ist komplex. An dieser Stelle spielt die KI (künstliche Intelligenz) eine entscheidende Rolle. KI-Algorithmen helfen dieses bikriterielle Problem zu lösen: die Temperaturschwankungen zu minimieren, um die Lebensdauer des Geräts in zu verlängern, und gleichzeitig die Energieeffizienz Eff sicherzustellen. Dies wird erreicht, indem die intelligenteste Abkühlungsstrategie im Kontext des aktuellen Lastprofils P(t) und der Kühlungsmöglichkeiten bestimmt wird. Mittlere Effizienz Eff (%) und relative Lebensdauerverlängerung (Increase of Lifetime) Inc (%) sind beispielsweise in den Diagrammen in den Figuren 5 und 6 in Abhängigkeit von der aktuellen Leistung in Bezug auf die Nominalleistung Ref (%) aufgetragen. Die Leistung bezieht sich dabei auf die zusätzlich eingesetzte Leistung zur Reduktion des Abkühlverhaltens und nicht auf die Leistung eines Gerätes.

Basiert die Temperatursteuerung T-con auf einem Lebensdauermodell für das Gerät inv, das einen Temperaturzyklus in einen monetären Wert umwandelt, zum Beispiel unter Berücksichtigung der Kosten für den Geräteaustausch, reduziert sich dieses Problem auf ein eindimensionales konvexes kontinuierliches Optimierungsproblem, das konventionell gelöst werden kann, beispielsweise mit Line-Search-Methoden.

Typischerweise erfordert die Temperatursteuerung T-con das Temperaturprognoseprofil Tf als Eingabe. Alternativ kann das Lastprognoseprofil Pf oder sowohl das Last- als auch das Temperaturprognoseprofil Tf+Pf berücksichtigt werden.

Schließlich ist noch die Steuerung inv-con des elektronischen Bauteils inv, insbesondere eine Wechselrichtersteuerung, eine weitere Komponente der geschlossenen Regelung zur Temperaturanpassung. Diese Steuerung inv-con ist insbesondere so konfiguriert, dass sie direkte Sollwerte von der Temperatursteuerung T-con empfängt, um thermische und elektrische Leistungsparameter zu verwalten. Diese Sollwerte, die darauf abzielen, das Temperaturprofil T(t) zu optimieren, können Anpassungen der Blindleistung, Variationen der Schaltfrequenz und Modulation der Schaltgeschwindigkeit umfassen. Anstatt entsprechende Daten intern zu verarbeiten, agiert die Bauteilsteuerung inv-con gemäß diesen spezifischen Anweisungen. Insbesondere werden dadurch die konventionellen, effizienzoptimierten Operationen der Bauteilsteuerung inv-con modifiziert.

Um diese Interaktion zwischen der Temperatursteuerung T-con und der Bauteilsteuerung inv-con noch zu verbessern, kommuniziert das Bauteil inv seine aktuellen Betriebsparameter an die Temperatursteuerung T-con. Diese Kommunikation ermöglicht es der Temperatursteuerung T-con, diese Betriebsparameter beziehungsweise Anforderungen bei der Bestimmung des optimalen Temperaturprofils und der entsprechenden Sollwerte zu berücksichtigen.

Die Bauteilsteuerung inv-con kann demnach ihre Operationen basierend auf den Temperatursteuerung T-con anpassen, beispielsweise durch die Erzeugung zusätzlicher thermischer Verluste durch eine Frequenzsteuerung oder durch den Einsatz einer Blindleistungsregelung. Die Bauteilsteuerung inv-con gibt die tatsächlichen Temperaturwerte T an die Temperatursteuerung T-con sowie an das Temperatursimulationsmodell T-sim zurück. Darüber hinaus kommuniziert sie die aktuellen Betriebszustände P an die KI zur Schulung und Aktualisierung der Prognose Pf.

Das KI-Modell AI-Pf wird kontinuierlich mit aktuellen Betriebsdaten T, P aktualisiert. Es aktualisiert die Lastprofilprognosen Pf regelmäßig, wobei das Aktualisierungsintervall weit kleiner sein sollte als der Prognosehorizont. Das heißt, etwa eine Aktualisierung pro Minute für einen 15-minütigen Zeithorizont wäre eine gute Lösung, die Berechnungsaufwand, Genauigkeit des thermischen Managements und Leistung dieser geschlossenen Regelung berücksichtig. Immer wenn eine neue Aktualisierung bereitgestellt wird, wird sie von der Temperatursimulation T-sim und der Temperatursteuerung T-con verarbeitet, um aktualisierte Empfehlungen an die Bauteilsteuerung inv-con zu geben.

Ein besonderer Vorteil der vorgeschlagenen Lösung liegt in ihrem iterativ korrektiven Ansatz, der Echtzeit-Datenanalyse, cloud-basierte Digital-Twin-Technologie und maschinelle Lernalgorithmen synergiert. Damit wird erzielt ein genau prognostiziertes Temperaturniveau aufrechtzuerhalten. Die Ableitung optimaler Betriebsbedingungen wird erleichtert, welche darauf abzielen, die Lebensdauer zu verbessern und die Effizienz zu optimieren, wobei verschiedene Parameter wie Investitionskosten, Energiekosten und CO₂-Fußabdruck berücksichtigt werden können, um die nachhaltigste wirtschaftliche Lösung zu erhalten. Vergleiche dazu die Figuren 3 bis 6.

Figur 3 zeigt eine prognostizierte Leistung P(kW) und Figur 4 zeigt die daraus resultierende prognostizierte Temperatur T(°C), insbesondere eine Kühlkörper- oder Bauelementtemperatur, als Funktion der Zeit t. Figur 5 zeigt die Verlängerung der Lebensdauer Inc (%) gegenüber dem Verlust an Effizienz Eff(%) in Figur 6 als Funktion des minimalen Leistungsreferenzwerts Ref in %. Die vorgeschlagene Lösung integriert eine Zustandsüberwachung und ermöglicht dadurch auch eine bedarfsgesteuerte Wartung, was zu weiteren Vorteilen führt:
Die Nutzung von Echtzeitdaten T, P in Kombination mit den Vorhersagefähigkeiten von maschinellen Lernalgorithmen Al-Pf erhöht signifikant die Qualität der Systemleistungsprognose Pf. Dies ermöglicht proaktive Anpassungen im Betrieb, um potenzielle Probleme frühzeitig zu erkennen und zu beheben. Durch kontinuierliche Analyse der Betriebsbedingungen und entsprechende Anpassung der Strategien maximiert die vorgeschlagene Lösung die Lebensdauer Inc der so gesteuerten elektronischen Geräte inv. Dies wird durch optimales Management von Betriebsbelastungen inv-con und Temperaturen T-con erreicht. Dadurch werden Faktoren minimiert, die häufig zu vorzeitigem Verschleiß und Ausfällen führen. Zudem wird eine effizientere Wartung gewährleistet. Die Möglichkeit einer bedarfsgesteuerten Wartung, gestützt auf eine kontinuierliche Zustandsüberwachung, gewährleistet, dass Service und Reparaturen bei Bedarf durchgeführt werden, anstatt nach einem vorbestimmten Zeitplan. Dieser Ansatz spart nicht nur Ressourcen, sondern verhindert auch unnötige Ausfallzeiten des elektronischen Gerätes inv und verbessert die Gesamteffizienz des Systems.

Auch die Betriebseffektivität wird verbessert. Betriebsparameter T, P werden dynamisch an wechselnde Bedingungen angepasst, was zu einer effektiveren Nutzung von Energie und Ressourcen führt. Dies ist besonders vorteilhaft in Szenarien, in denen der Leistungsbedarf variabel und unvorhersehbar ist. Dazu kommen verbesserte Analysefähigkeiten: Der cloud-basierte Digital-Twin-Ansatz bietet eine anspruchsvolle Analyseplattform, die ein tieferes und umfassenderes Verständnis der Betriebsdynamik und der Auswirkungen verschiedener Faktoren auf die Systemleistung P ermöglicht. Die vorgeschlagene Lösung basiert auf einem ganzheitlichen, datengetriebenen Ansatz und gewährleistet also nicht nur optimale Effizienz Eff und verlängerte Lebensdauer Inc, sondern bringt auch erhebliche Verbesserungen in Bezug auf Vorhersagbarkeit, Wartungseffizienz und Gesamtbetriebseffektivität. Dies trägt zur Nachhaltigkeit bei und etabliert einen Datenfluss zwischen Fertigungsbereich, Edge und optional Cloud für intelligente, softwarebasierte Automatisierung und IT/OT-Integration.

Zusammenfassend kann festgehalten werden, dass das vorgeschlagene computerimplementierte Verfahren folgende Aspekte aufweist: die Laststeuerung überträgt aktuelle Temperaturmessdaten des elektronischen Bauteils an die Temperaturregulierung sowie an die Temperatursimulation, aktuelle Lastmessdaten und Temperaturmessdaten des elektronischen Bauteils werden außerdem an die Kt-basierte Lastprognose und an das KI-Training übertragen. Es erfolgt eine Priorisierung der Lebensdauerverlängerung gegenüber der sofortigen Effizienzmaximierung, da die Lebensdauer zu einem kritischen Designkriterium in der gesamten Elektronik geworden ist. Dazu wird eine Temperaturregulierung des elektronischen Bauteils mittels der Laststeuerung sowie wahlweise aktivem Wärmemanagement vorgenommen

### Bezugszeichenliste

- t: Zeit, Zeitpunkt
- d: Datum, weitere anwendungsspezifische Parameter
- tr: KI-Training
- Al-Pf: Al- beziehungsweise KI-basierte Lastprognose
- Pf: Lastprognose
- T-sim: Temperatursimulation
- Tf: Temperaturvorhersage, Temperature forecast
- cf: sonstige Parameter, zum Beispiel Benutzerkonfiguration, Strompreis
- T-con: Temperaturregulierung, Temperature control
- inv-con: Laststeuerung des elektronischen Bauteils
- inv: Elektronisches Bauteil, beispielsweise Inverter
- SW: Softwarekomponente, insbesondere auf einem Edge Device
- HW: Hardwarekomponente, insbesonder elektronische Bauteil mit integrierter Last- und Temperatursteuerung
- P, T: Leistungs- und Temperaturmessdaten
- t(s): Zeit in Sekunden
- P(kW): Leistung in Kilowatt
- T (°C): Temperatur in Grad Celsius
- Ref (%): aktuelle Leistung in Bezug auf die Nominalleistung in Prozent
- Eff (%): Mittlere Effizienz
- Inc (%): Increase of Lifetime, relative Lebensdauerverlängerung

## Patentansprüche

1. Computerimplementiertes Verfahren umfassend eine Temperaturregulierung (T-con) eines elektronischen Bauteils (inv), insbesondere eines leistungselektronischen Bauteils,
wobei für die Temperaturregulierung (T-con) eine Lastprognose (Pf) für das elektronische Bauteil (inv) in eine Temperatursimulation (T-sim) eingeht, mittels welcher eine Temperaturvorhersage (Tf) über einen bestimmten Zeitraum für das elektronische Bauteil (inv) bestimmt wird und
wobei in die Temperatursimulation (T-sim) außerdem Lastmessdaten (P) sowie Temperaturmessdaten (T) des elektronischen Bauteils (inv) eingehen,
wobei die Lastprognose (Pf) Kt-basiert (Al-Pf) erstellt wird und beruhend auf Lastprognose (Pf) und Temperaturvorhersage (Tf) eine Temperaturregulierung (T-con) des elektronischen Bauteils (inv) über die Laststeuerung (inv-con) erfolgt.

2. Computerimplementiertes Verfahren nach Anspruch 1, wobei die Laststeuerung (inv-con), basierend auf Sollwerten empfangen aus der Temperaturregulierung (T-con), thermische als auch elektrische Leistungsparameter des elektronischen Bauteils (inv) steuert.

3. Computerimplementiertes Verfahren nach Anspruch 2, wobei die Laststeuerung (inv-con) insbesondere eine Anpassung einer Blindleistung, eine Variation einer Schaltfrequenz oder eine Modulation einer Schaltgeschwindigkeit umfasst.

4. Computerimplementiertes Verfahren nach einem der vorstehenden Ansprüche, wobei das elektronische Bauteil (inv) Werte, insbesondere Betriebsgrenzwerte, an die Temperaturregulierung (T-con) mitteilt.

5. Computerimplementiertes Verfahren nach einem der vorstehenden Ansprüche, wobei die Temperaturmessdaten (T), welche in die Temperatursimulation (T-sim) eingehen, zumindest die Temperatur einer Komponente des elektronischen Bauteils (inv) umfassen, insbesondere die Temperatur einer Kühlkomponente.

6. Computerimplementierte Verfahren nach Anspruch 5, bei dem Temperaturwerte (T) weiterer einzelner Komponenten des elektronischen Bauteils (inv), insbesondere einzelner IGBTs und/oder Dioden, anhand eines thermischen Modells berechnet werden.

7. Computerimplementiertes Verfahren nach einem der Ansprüche 5 oder 6, bei dem basierend auf der Lastprognose (Pf) für mehrere Komponenten innerhalb des elektronischen Bauteils (inv) jeweils ein individuelles Temperaturprofil generiert wird.

8. Computerimplementiertes Verfahren nach einem der vorstehenden Ansprüche, wobei die Temperaturregulierung (T-con) des elektronischen Bauteils (inv) mittels aktivem Wärmemanagement erfolgt.

9. Computerimplementiertes Verfahren nach Anspruch 8, wobei das aktive Wärmemanagement einen Abkühlprozesses umfasst, welcher wiederum eine Steuerung eines Flüssigkeitspumpenstroms, eine Steuerung einer Lüfterdrehzahl, eine Regelung einer Blindleistung, eine Regelung einer Energieabgabe und/oder ein Anlegen einer disponierbaren Last zur Feinabstimmung der Abkühlfähigkeit umfasst.

10. Computerimplementiertes Verfahren nach Anspruch 8 oder 9, wobei ein Zwei-Kriterien-Problem, insbesondere aus Temperaturschwankungsminimierung und Energieeffizienz oder Energieverfügbarkeit gelöst wird, insbesondere mittels eines KI-Algorithmus, und das aktive Wärmemanagement auf die Abkühlfähigkeit des im elektronischen Bauteil (inv) eingesetzten Abkühlsystems abgestimmt ist.

11. Computerimplementiertes Verfahren nach einem der vorstehenden Ansprüche, bei dem ein Dateninput (P, T, tr) in die Kt-basierte Lastprognose (Al-Pf) erfolgt, insbesondere ein Dateninput, der eine Datenhistorie umfasst.

12. Computerimplementiertes Verfahren nach einem der vorstehenden Ansprüche, bei dem ein Input von Messdaten (T, P) des elektronischen Bauteils (inv) in die Kt-basierte Lastprognose (Al-Pf) erfolgt.

13. Computerimplementiertes Verfahren nach einem der vorstehenden Ansprüche, **dadurch gekennzeichnet, dass** die Lastprognose-Kl (Al-Pf) kontinuierlich während der Ausführung des Verfahrens trainiert (tr) wird.

14. Computerimplementiertes Verfahren nach Anspruch 13, bei dem ein Input von Lastmessdaten (P) und/oder Temperaturmessdaten (T) des elektronischen Bauteils (inv) in das KI-Training (tr) erfolgt.

15. Anordnung zur Durchführung eines computerimplementierten Verfahrens, nach einem der Ansprüche1 bis 14, umfassend eine Hardwarekomponente (HW), insbesondere umfassend ein elektronisches Bauteil (inv) mit Laststeuerung (inv-con) und Temperaturregulierung (T-con), sowie eine Softwarekomponente (SW), insbesondere umfassend Temperatursimulation (T-sim) und Klbasierte Lastprognose (Al-Pf).
